Europäisches Patentamt

European Patent Office

Office européen des brevets

(11) Veröffentlichungsnummer: **0 498 043 A2**

# EUROPÄISCHE PATENTANMELDUNG

(21) Anmeldenummer: **91119107.0**

(22) Anmeldetag: **09.11.91**

(51) Int. Cl.5: **H05K 3/00**

(30) Priorität: **05.02.91 DE 4103375**

(43) Veröffentlichungstag der Anmeldung:
**12.08.92 Patentblatt 92/33**

(84) Benannte Vertragsstaaten:
**AT CH DE FR GB IT LI NL SE**

(71) Anmelder: **Firma Carl Freudenberg**
**Höhnerweg 2-4**
**W-6940 Weinheim/Bergstrasse(DE)**

(72) Erfinder: **Kober, Horst**
**Berggewann 5**
**W-6940 Weinheim(DE)**

(54) **Starre und flexible Bereiche aufweisende Leiterplatte und Verfahren zu ihrer Herstellung.**

(57) Eine starre und flexible Bereiche aufweisende Leiterplatte enthält außer der oder den starren Lage-(n) eine Lage aus mit flexiblem, ausgehärtetem Kunstharz beschichtetem und imprägniertem, temperaturbeständigem Vliesstoff oder Papier, die sowohl eine Verbundfolie als auch das Substrat für die Leiterbilder im flexiblen Bereich der Leiterplatte darstellt. Das Herstellungsverfahren für die Leiterplatte besteht darin, daß am jeweils flexibel zu gestaltenden Bereich aus der oder den starren Lage (n) (1) vor dem Laminieren des Einzellagen-Verbundes ein in seinen Abmessungen mit diesem Bereich identisches Füllstück (3) herausgestanzt und sogleich danach auf umgekehrtem Wege in das Stanzfenster paßgenau wieder eingesetzt und anschließend ein mit Kunstharz beschichteter und imprägnierter Vliesstoff bzw. das so vorbereitete Papier als Prepreg (5) direkt und vollflächig schaltungsseitig auf die gesamte starre Einzellage (1) aufgelegt wird. Im später flexiblen Bereich wird dabei das Haften des Prepregs (5) durch eine vorher aufgebrachte Trennschicht (4) auf der starren Lage verhindert. Es folgen das Belegen des Prepregs (5) mit der duktilen Kupferfolie (22), das Formen der Leiterbilder (24) und das Entfernen des Füllstücks (3) im flexiblen Bereich der starren Einzellage (1).

Fig. 1

Die Erfindung betrifft eine starre und flexible Bereiche aufweisende Leiterplatte mit einer oder mehreren starren Lage(n) und mit Leiterbildern im starren und flexiblen Bereich, wobei die Leiterbilder im starren Bereich mittels einer Verbundfolie mit dem darunter liegenden, starren Material verbunden sind. Ferner betrifft die Erfindung ein Verfahren zur Herstellung einer solchen Leiterplatte.

Die europäische Patentanmeldung 89113039.5 (noch nicht veröffentlicht) enthält ein Verfahren zur Herstellung von gattungsgemäßen Leiterplatten, wobei an jedem flexibel zu gestaltenden Bereich aus der starren Isoliermaterialschicht vor dem Laminieren des Einzellagen-Verbundes ein in seinen Abmessungen mit diesem Bereich identisches Flächenstück herausgestanzt und sogleich danach als Füllstück auf umgekehrtem Wege in das Stanzfenster paßgenau wieder eingesetzt wird. Durch dieses Verfahren werden die Nachteile der bisher üblichen Trennfugen um den flexiblen Bereich herum bei der Fertigung vermieden.

Die deutsche, noch nicht veröffentlichte Patentanmeldung P 40 03 345.7 lehrt ein Verfahren zur Herstellung einer starre und flexible Bereiche aufweisenden Leiterplatte, bei dem nach dem Ausbilden der Bruchstellen um den flexiblen Bereich herum eine Isolationsfolie mittels einer nicht fließenden Kleberschicht auf die starre Einzellage schaltungsseitig und nur im flexibel zu gestaltenden Bereich aufgeklebt wird, wobei die Isolationsfolie allseitig die Abmessungen des flexiblen Bereichs etwas überragt. Die Isolationsfolie wird mit einer zusätzlichen Kleberschicht auf ihrer der Einzellage abgewandten Seite versehen und ein Prepreg aufgelegt, das gleich dick wie oder einige µm dicker ist als die Isolationsfolie einschließlich Kleberbeschichtung, auf diese Beschichtung überdeckend aufgetragen. Das Prepreg muß im flexiblen Bereich ausgespart sein. Über das gesamte Prepreg wird eine durchgehende Kupferfolie aufgelegt, der Verbund unter Druck und bei einer Temperatur, die Kleber und Prepreg klebend aktiviert, zu einem Laminat verpreßt, die Kleberverbindung aushärten gelassen und die Leiterbilder nach üblichen Verfahren hergestellt. Nach der Konturbearbeitung wird im flexiblen Bereich die Einzellage mit der Kupferbeschichtung entlang der Sollbruchstellen entfernt.

Nachteilig ist bei diesem Verfahren, daß die Isolationsfolie exakt zu den Sollbruchstellen der starren Einzellage positioniert werden muß, daß eine zusätzliche Kleberschicht zur Verklebung der Kupferfolie eingesetzt und deren Dicke derjenigen des Isolationsfolienstücks angepaßt werden muß. Nur damit werden Lufteinschlüsse am Rand der Isolationsfolie vermieden. Außerdem hat diese eine nicht sehr klebefähige Oberfläche, so daß schwankende Haftwerte zwischen Kupferfolie und Polyimidfolie nach dem Verpressen auftreten können.

Die deutsche, nicht veröffentlichte Patentanmeldung P 40 26 353.3 beschreibt die Verwendung eines Vliesstoffs oder Papiers, welches beschichtet und imprägniert ist mit dem chemischen Vernetzungsprodukt aus

a) der 50%igen, wäßrigen Dispersion eines thermisch vernetzbaren Copolymerisats mit einer Glasübergangstemperatur von + 33° C aus Acrylnitril und Styrol

und aus

b) der 60%igen, wäßrigen, Methylolgruppen enthaltenden Lösung eines Amino- oder Phenoplast-Vorkondensats, in Verbindung mit

c) rotem Phosphor mit einer Korngröße von 0,045 bis 0,10 mm und

d) Ammoniumpolyphosphat mit einer Korngröße von 0,025 bis 0,075 mm,

wobei die Auftragsmenge (trocken) 30 bis 60 $g/m^2$ beträgt, als Abdeckfolie für flexible Leiterplatten, wobei das Verhältnis a:b (trocken) 10:0,8 bis 10:2,0, dasjenige von c:d 1:10 und das aus (a + b) und (c + d) 1:0,9 beträgt. Das Substrat dieser Abdeckfolie besteht aus temperaturbeständigen Fasern, die, ebenso wie die Beschichtung/Imprägnierung beständig gegen Lötbäder sind (290° C, 20 s) und ein Brandverhalten nach UL 94, Klasse V0, erfüllen.

Der Erfindung liegt die Aufgabe zugrunde, eine starre und flexible Bereiche aufweisende Leiterplatte sowie ein Verfahren zu deren Herstellung anzugeben, bei der auf genau zu positionierende, flexible Isolierfolien und teilweise flexible Einzellagen und Klebeschichten verzichtet werden kann. Dabei soll der Lagenaufbau mit der geringstmöglichen Anzahl von Schichten auskommen und so homogen sein, daß eine große Dickenausdehnung bei hohen Temperaturen, eine hohe Wasseraufnahme sowie die geringe Klebefähigkeit von Isolationsfolien vermieden werden.

Die Lösung dieser Aufgabe besteht in einer gattungsgemäßen Leiterplatte mit den kennzeichnenden Merkmalen des ersten Patentanspruchs sowie in einem Herstellungsverfahren mit den Kennzeichen des ersten Verfahrensanspruchs. Vorteilhafte Ausgestaltungen des erfindungsgemäßen Gegenstandes/Verfahrens sind in den Unteransprüchen aufgezeigt.

Die starre Einzellage kann eine ein- oder zweiseitige Kupferfolienkaschierung besitzen. Das entfernbare, starre Füllstück im flexiblen Bereich wird ausgestanzt und sofort wieder eingesetzt, was zu einer fugendichten Ausfüllung des flexiblen Bereichs führt. Das starre Füllstück wird schaltungsseitig mit einer bei 290° C bis zu 20s lang temperaturbeständigen Trennschicht, zum Beispiel einer PTFE-Schicht, versehen.

Auf die so ausgebildete starre Einzellage wird zuerst ganzflächig ein Vliesstoff- oder Papier-Prepreg aufgelegt. Die Vliesstoffasern oder das Papier müssen dabei lötbadbeständig sein, also Temperaturen bis zu 290° C mindestens 20s lang überstehen können, ohne Schaden zu nehmen.

Das Vliesstoff- bzw. Papier-Prepreg ist beschichtet und imprägniert mit einem härtbaren Kunstharz, wobei aus der Vielzahl der hierzu zur Verfügung stehenden Polymersysteme diejenigen ausgewählt werden müssen, die die folgenden Anforderungen in ihrer Gesamtheit erfüllen:

- Temperaturbeständigkeit bis 290° C für mindestens 20s,
- mit dem die starre Einzellage bildenden Werkstoff dauerhaft verklebbar, d.h. chemisch verwandte Polymersysteme,
- flexibel im ausgehärteten Zustand.

Eine solche Auswahl ist anhand der stets verfügbaren Datenblätter der Herstellerfirmen und in wenigen Fällen durch zusätzliche, einfache Vorversuche mühelos zu treffen. So wird man bei Verwendung der weit verbreiteten Einzellagen aus Epoxidglashartgewebe auf ein flexibel eingestelltes Epoxidharz auch als Imprägnierung/Beschichtung zurückgreifen. Es ist fertig im Handel erhältlich.

Mit ebenfalls gebräuchlichen Einzellagen, die aus einer Mehrzahl acrylatgebundener Vliesstoffschichten aufgebaut sind, verbindet sich am besten eine Imprägnierung und Beschichtung aus einem mit Melaminharz modifizierten, vernetzbaren Polyacrylatsystem, wie es in der eingangs genannten deutschen Patentanmeldung P 40 26 353.3 bereits zur Herstellung eines Prepregs als Abdeckfolie für flexible Leiterplatten vorgeschlagen worden ist.

Weitere Polymersysteme, die die genannten Anforderungen für Imprägnier-Kunstharze erfüllen, sind ungesättigte Polyester mit Epoxidacrylat-Anteil, beschrieben in der europäischen Patentanmeldung EP-A 0 217 311, oder auch im Handel erhältliches vernetztes Polyesterharz. Jeweils ist die autogene Verklebbarkeit des Prepregs mit der zur Verfügung stehenden starren Einzellage zu prüfen, was jedoch dem Fachmann aufgrund seiner Kenntnisse bezüglich der chemischen Verwandtschaft von Polymerwerkstoffen keine Schwierigkeiten bereitet. Über das Prepreg wird ganzflächig eine duktile Kupferfolie gelegt, wie sie üblicherweise für flexible Basismaterialien Verwendung findet. Sodann wird der Verbund unter einem Druck von 10 bis 30 bar und einer Temperatur von 170 bis 200° C verpreßt, wobei das Prepreg die duktile Kupferfolie mit der starren Einzellage in den starren Bereichen verklebt, im später flexiblen Bereich jedoch wegen der Trennfolie nur mit der Kupferfolie. Da das starre Füllstück für den später flexiblen Bereich gemäß europäischer Patentanmeldung 89113039.5 zuvor ausgestanzt wurde, sind die es umgebenden Fugen so eng, daß beim Laminieren ein Eindringen von flüssigem Harz aus dem Prepreg sicher verhindert wird.

Der starr-flexible Verbund kann nach den bekannten Methoden für starre Leiterplatten mit einem Leiterbild versehen und endbearbeitet werden. Nach dem Herstellen der Außenkontur läßt sich das starre Füllstück im flexiblen Bereich leicht entfernen, und die starr-flexible Leiterplatte in ihrer endgültigen Konfiguration ist fertig.

Der flexible Bereich besteht bei der fertigen Leiterplatte nur aus dem Vliesstoff- oder Papier-Prepreg mit aufgeklebten Leiterbildern; im ausgehärteten Zustand zeichnet sich diese Prepreg-Folie durch eine besonders hohe Einreiß- und Weiterreißfestigkeit und eine so hohe Flexibilität aus, daß der flexible Bereich auch geknickt oder gefaltet werden kann, ohne zu brechen. Dies ist bei Prepregs mit Glasgewebe nicht möglich. Die fertige Leiterplatte enthält keine spezielle flexible Isolierfolie zwischen den Leiterbildern und der starren Basis; ebenso entfällt die separate Kleberschicht zwischen der die Leiterbahnen tragenden Folie und dem starren Material bzw. der Kupfer-Leiterbahnen.

Die das Leiterbild tragende Prepreg-Vliesstoff- oder -Papierschicht ist identisch mit dem Material, welches den flexiblen Bereich bildet. Die starr-flexible Leiterplatte zeichnet sich daher durch einen homogenen Lagenaufbau aus, wobei die bisherigen Nachteile entfallen, wie hohe thermische Dickenausdehnung, hohe Wasseraufnahme und geringe Klebefähigkeit bisher verwendeter Polyimidfolien. Der Lagenaufbau kommt mit der geringstmöglichen Anzahl von Schichten aus, auch die Zahl der Arbeitsschritte, insbesondere das aufwendige Positionieren von im flexiblen Bereich ausgesparten Folienstücken, entfällt.

In einer Weiterentwicklung der Erfindung können mehrere starre Einzellagen ausgestanzt und danach zu einer großen Tafel zusammengelegt werden. Danach werden ganzflächig schaltungsseitig der beschichtete und imprägnierte Vliesstoff bzw. ein solches Papier und darauf die duktile Kupferfolie gelegt. Das Verpressen kann in großen Laminieranlagen somit wirtschaftlich durchgeführt werden, und zwar deshalb, weil die Erfindung die Registrierung der Kupferfolie und des Prepregs relativ zur starren Einzellage unkritisch macht, da nur die starre Einzellage den Umfang der flexiblen Bereiche bestimmt.

In einer weiteren Ausgestaltung der Erfindung kann der flexible Bereich noch mit einer Deckfolie, vorzugsweise aus Polyimid, abgedeckt werden, was die mechanische Stabilität des flexiblen Teils weiter erhöht.

Im Rahmen dieser Ausgestaltung liegt eine Weiterentwicklung darin, diese Polyimid-Deckfolie nicht schlüssig mit der Außenkontur des flexiblen Bereichs abzuschließen, sondern über die Außenkanten des imprägnierten/beschichteten Vliesstoffs oder Papiers 0,5 bis 1 mm überstehen zu lassen. Die Einreißfestigkeit des flexiblen Teils wird somit durch die Kante der Deckfolie bestimmt, welche sich gewissermaßen an den Außenkanten der Leiterplatte "abstützt". Man erhält so zwei Effekte: Die Einreißfestigkeit des flexiblen Teils wird durch die Polyimid-Deckfolie bestimmt (sie ist höher als die Einreißfestigkeit des Vliesstoff- oder Papier-Prepregs). Die Weiterreißfestigkeit hingegen des flexiblen Teils wird durch das Vliesstoff- oder Papier-Prepreg bestimmt, da dieser Wert höher ist als derjenige der Polyimid-Folie. Im Interesse einer sicheren Verklebung überragen die beiden den starren Bereichen zugewandten Kanten der Deckfolie diese Bereiche um jeweils mindestens 1 mm.

Figur 1    zeigt den Lagenaufbau des starr-flexiblen Verbundes vor dem Laminieren,

Figur 2    den starr-flexiblen Nutzen nach der Leiterbild-Strukturierung, von der flexiblen Seite, und

Figur 3    die starr-flexible Leiterplatte mit überstehender Deckfolie im flexiblen Bereich nach der Konturbearbeitung, von der flexiblen Seite her gesehen.

Die Bezugzeichen bedeuten:

1    starre Einzellage
2    Fugen entlang der Trennungslinie zwischen starren Teilen und flexiblem Teil
3    starres Füllstück im flexiblen Bereich
4    Trennschicht auf dem Füllstück
5    Vliesstoff-oder Papier-Prepreg
6    Polyimid-Deckfolie
7    Überstand der Polyimid-Deckfolie 6 über die Außenkontur des flexiblen Teils 31
21    Kupferfolie, zugehörig der starren Einzellage 1
22    Duktile Kupferfolie, schaltungsseitig auf dem Prepreg
23    Lötaugen
24    Leiterbild
30    Konturen der starren Teile
31    Kontur des flexiblen Teils

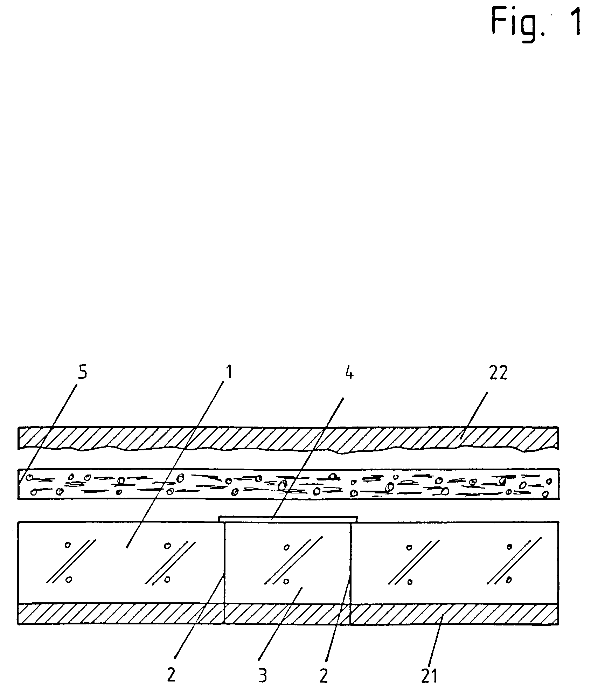

Zunächst bei Figur 1 betrachtet. Die starre Einzellage 1 trägt eine einseitige Kupferkaschierung 21. Im flexiblen Bereich wurde ein Teilstück 3 ausgestanzt und paßgenau wieder eingesetzt. Die Fugen 2 entlang der Trennlinien zwischen den starren Teilen und dem flexiblen Teil sind völlig dicht. Das Teilstück 3 ist schaltungsseitig mit einer temperaturbeständigen Trennschicht 4 versehen worden. Auf die so bearbeitete starre Einzellage 1 wird zunächst ganzflächig das Vliesstoff- oder Papier-Prepreg 5 gemäß der Erfindung gelegt. Darüber wird, ebenfalls ganzflächig, eine duktile Kupferfolie 22 aufgebracht.

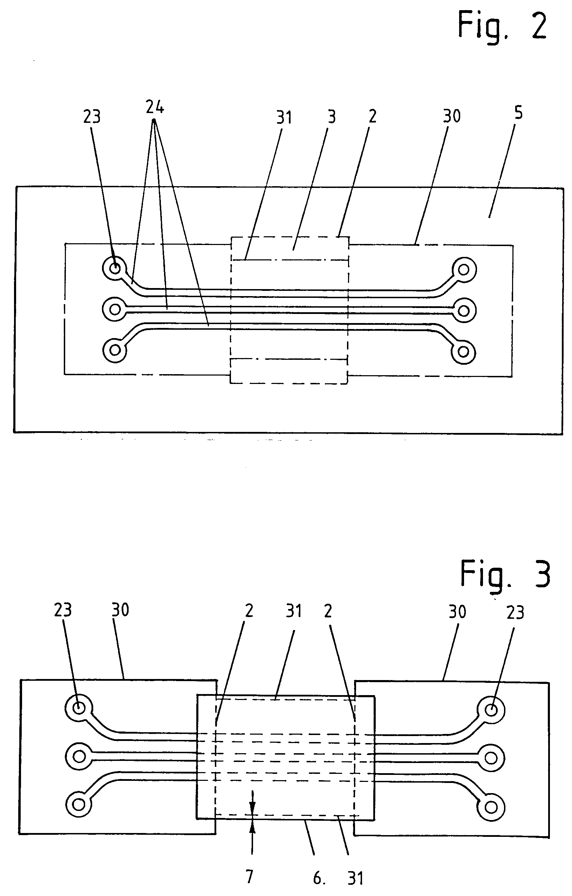

In Figur 2 sieht man, wie die flexible Seite von dem ausgehärteten Vliesstoff- oder Papier-Prepreg 5 gebildet wird. Die Leiterbilder 24 auf dieser Seite verlaufen über die starren und flexiblen Bereiche hinweg. In den starren Bereichen befinden sich die durchkontaktierten Lötaugen 23. Die Konturbearbeitung erfolgt durch Fräsen oder Stanzen entlang der Kontur 30 der starren Teile und der Kontur 31 des flexiblen Teils. Nach der Konturbearbeitung kann das Füllstück 3 wegen der bereits vorhandenen Trennfugen 2 leicht entfernt werden.

Nach der Konturbearbeitung (Figur 3) wird zur Verstärkung des flexiblen Bereichs eine Polyimid-Deckfolie mit der Kontur 6 so auflaminiert, daß sie mindestens 1 mm über die Außenkontur 31 des flexiblen Teils hinaus zum jeweils starren Bereich übersteht. Somit kann die Folie 6 mit den starren Bereichen beidseitig verklebt werden. Die beiden nicht den starren Bereichen zugewandten Kanten der Deckfolie 6 überragen die Kante 31 des flexiblen Teils zweckmäßig um 0,5 bis 1 mm (Überstand 7).

**Patentansprüche**

1.   Starre und flexible Bereiche aufweisende Leiterplatte mit einer oder mehreren starren Lage(n) und einer die Schaltung mit der oder den starren Lage(n) verbindenden Verbundfolie, dadurch gekennzeichnet, daß sowohl der Leiterbilder tragende, flexible Bereich wie auch die Verbundfolie aus ein und derselben Lage bestehen, die aus mit flexiblem Epoxidharz beschichtetem und imprägniertem, temperaturbeständigem Vliesstoff oder Papier aus temperaturbeständigen Fasern gebildet ist und daß die Beschichtung/Imprägnierung ein bis mindestens 290° C während 20s stabiles, flexibles, ausgehärtetes Kunstharz ist, welches mit der starren Einzellage (1) verklebt ist.

2.   Leiterplatte nach Anspruch 1, dadurch gekennzeichnet, daß das Kunstharz ein flexibles Epoxidharz ist und die starre Einzellage aus Epoxidglashartgewebe besteht.

3.   Leiterplatte nach Anspruch 1, dadurch gekennzeichnet, daß das Kunstharz ein mit Melaminharz modifiziertes, vernetztes Polyacrylatsystem gemäß deutscher Patentanmeldung P 40 26 353.3 ist und die starre Einzellage aus einer Mehrzahl acrylatgebundener Vliesstoffschichten aufgebaut ist.

4.   Verfahren zur Herstellung einer starre und flexible Bereiche aufweisenden Leiterplatte, wobei am jeweils flexibel zu gestaltenden Bereich aus der oder den starren Lage(n) (1) vor dem Laminieren des Einzellagen-Verbundes ein in seinen Abmessungen mit diesem Bereich identisches Füllstück (3) herausgestanzt und sogleich danach auf umgekehrtem Wege in das Stanzfenster paßgenau wieder eingesetzt wird, wobei danach eine durchgehende, hochduktile Kupferfolie (22) schaltungsseitig mit einer haftvermittelnden Folie auf die Einzellage (1) oder den Einzellagen-Verbund aufgelegt sowie im später flexiblen Bereich die schaltungtragende, flexible Folie gebildet wird, dadurch gekennzeichnet, daß nach dem Ausstanzen und Wiedereinsetzen im später flexiblen Bereich das Füllstück (3) schaltungsseitig mit einer bis 290° C/20s beständigen Trennschicht (4) belegt wird, daß anschließend schaltungsseitig vollflächig eine Lage aus härtbarem Kunstharz mit beschichtetem und imprägniertem, bis 290° C/20s temperaturbeständigem Vliesstoff oder Papier als Prepreg (5) aufgelegt wird, wobei als härtbares Kunstharz ein bis 290° C/20s beständiges, mit der starren Lage dauerhaft verklebbares und im ausgehärteten Zustand flexibles Polymersystem gewählt wird, daß darauf das Belegen mit der duktilen Kupferfolie (22) erfolgt, daß danach bei 10 bis 30 bar Druck und bei einer Temperatur von 170 bis 200° C der Verbund verpreßt und zuletzt das starre Füllstück (3) herausgenommen wird.

5. Verfahren nach Anspruch 4, dadurch gekennzeichnet, daß man als härtbares Kunstharz ein flexibles Epoxidharz einsetzt und eine starre Einzellage aus Epoxidglashartgewebe verwendet.

6. Verfahren nach Anspruch 4, dadurch gekennzeichnet, daß man als härtbares Kunstharz ein mit Melaminharz modifiziertes Polyacrylatsystem gemäß deutscher Patentanmeldung P 40 26 353.3 verwendet und eine starre Einzellage vorsieht, die aus einer Mehrzahl acrylatgebundener Vliesstoffschichten aufgebaut ist.

7. Verfahren nach Anspruch 4 bis 6, dadurch gekennzeichnet, daß der flexible Bereich zuletzt mit einer Polyimid-Deckfolie bedeckt wird.

8. Verfahren nach Anspruch 4 bis 7, dadurch gekennzeichnet, daß man mit der Polyimid-Folie (6) sowohl den flexiblen Bereich als auch das Vliesstoff- oder Papier-Prepreg (5) überdeckt, wobei die Folie die Außenkanten um 0,5 bis 1 mm überragt.

Fig. 1

Fig. 2

Fig. 3